(19) **Europäisches Patentamt**
**European Patent Office**
**Office européen des brevets**

(11) **EP 2 009 790 B1**

(12) **FASCICULE DE BREVET EUROPEEN**

(45) Date de publication et mention
de la délivrance du brevet:
**01.08.2012 Bulletin 2012/31**

(51) Int Cl.:
***H03J 3/08*** *(2006.01)*    ***H04B 5/02*** *(2006.01)*

(21) Numéro de dépôt: **08158734.7**

(22) Date de dépôt: **23.06.2008**

(54) **Méthode d'accord de la fréquence de résonance d'une antenne**

Abstimmungsmethode der Resonanzfrequenz einer Antenne

Method for tuning the resonant frequency of an antenna

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **25.06.2007 FR 0704523**

(43) Date de publication de la demande:
**31.12.2008 Bulletin 2009/01**

(73) Titulaire: **Apple Inc.
Cupertino, CA 95014 (US)**

(72) Inventeur: **Leray, Christian
95800, COURDIMANCHE (FR)**

(74) Mandataire: **Lang, Johannes et al
Bardehle Pagenberg
Prinzregentenplatz 7
81675 München (DE)**

(56) Documents cités:
**WO-A-2006/095186    US-B1- 6 236 843**

## Description

La présente invention concerne un dispositif d'émission/réception d'un système de transmission en champ proche, ledit dispositif d'émission/réception comportant une unité d'émission/réception reliée à un circuit résonnant comportant au moins un élément inductif servant d'antenne audit dispositif d'émission/réception pour l'émission d'un signal modulé délivré par ladite unité d'émission/réception ou pour la réception de signaux de transmission. La présente invention concerne une méthode d'accord de la fréquence de résonance d'un circuit résonnant comportant au moins un élément inductif servant d'antenne d'un dispositif d'émission/réception d'un système de transmission en champ proche sur la fréquence d'émission/réception dudit dispositif d'émission/réception.

Il est connu d'utiliser la technologie NFC (pour Near Field Communication : Communication en champ proche) pour établir une communication sans fil de courte portée de l'ordre de quelques centimètres et ainsi pouvoir échanger des informations, par exemple, entre un appareil mobile et une borne.

Cette technologie est par exemple utilisée pour l'identification, l'appareil mobile étant alors dit "tag" alors que la borne est généralement dit "récepteur". Lorsqu'il est à portée du récepteur, le tag transmet à ce dernier des informations d'identification qui peuvent alors servir à ouvrir une barrière, à autoriser une opération particulière, etc.

Le développement de cette technologie a amené à élargir son champ d'application à des paiements sécurisés mais aussi à l'échange d'informations en général telles que des bandes d'annonce de film, des informations touristiques accessibles à une borne d'accès, etc. L'appareil mobile peut être un appareil dédié ou, comme cela existe aujourd'hui, un téléphone mobile spécialement équipé.

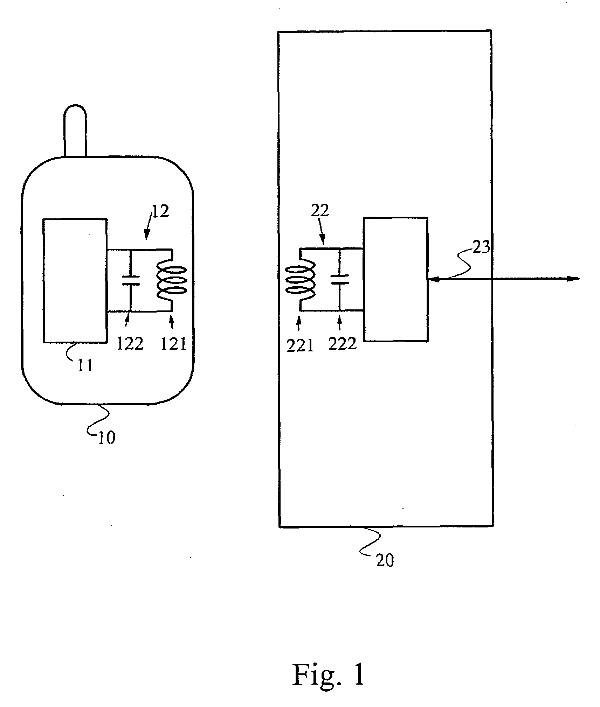

On a représenté à la Fig. 1, d'une part, un appareil mobile 10, qui peut être par exemple un téléphone mobile, et, d'autre part, une borne d'accès 20. L'appareil mobile 10 est équipé d'une unité d'émission/réception 11 qui est reliée à un circuit résonnant 12, constitué d'une inductance 121 et d'un condensateur 122. De même, la borne d'accès 20 est équipée d'une unité d'émission/réception 21 qui est reliée à un circuit résonnant 22 lui-même constitué d'une inductance 221 et d'un condensateur 222. L'unité d'émission/réception 21 de la borne d'accès 20 est reliée, par une liaison 23, à un centre d'information (non représenté).

Lorsque l'appareil mobile 10 est à courte distance de la borne d'accès 20, le circuit résonnant 12 ou 22 de celui de ces appareils qui fonctionne en émetteur rayonne en champ proche un champ magnétique qui est reçu par l'autre circuit résonnant 22 (respectivement 12). Les unités d'émission/réception 11 et 21 comportent des circuits de modulation/démodulation (non représentés) si bien que des informations sous forme de signaux modulés peuvent être échangées entre l'appareil mobile 10 et la borne d'accès 20 et réciproquement.

Pour que la transmission des signaux modulés ait lieu de manière efficace, il est nécessaire que les circuits résonnants 12 et 22 soient parfaitement accordés. Pour ce faire, chacun des circuits résonnants 12 et 22 est constitué, comme cela est visible à la Fig. 1, par une inductance 121, 221 et un condensateur 122, 222 dont les valeurs sont telles qu'ils forment entre eux un circuit résonnant à la fréquence de transmission de ces signaux modulés.

Un tel circuit résonnant est caractérisé à une fréquence donnée par son facteur de qualité, généralement noté Q, qui présente, en fonction de la fréquence, une courbe en forme de cloche avec une valeur maximale obtenue pour la fréquence de résonance du circuit résonnant. Or, plus la distance maximale entre l'appareil mobile 10 et la borne d'accès 20 en deçà de laquelle la transmission est assurée est importante, plus le facteur de qualité de chaque circuit résonnant doit être important. Pour ce faire, on cherche donc à se placer à une fréquence d'émission la plus proche possible de la fréquence de résonance de chaque circuit résonnant. Un tel circuit résonnant est divulgué par le brevet européen EP 0 663 724.

Un autre phénomène peut intervenir. Chaque circuit résonnant peut être perturbé et son accord être modifié, avec une diminution corrélative de son facteur de qualité, par la présence d'objets à proximité, tels que des objets métalliques qui modifient de manière significative la valeur de l'inductance du circuit, mais aussi par des effets de température.

Le but de la présente invention est de proposer un procédé pour résoudre les problèmes évoqués ci-dessus et ainsi prévoir un tel dispositif dont au moins l'un des circuits résonnants est pourvu de moyens d'accord adaptatif de manière à toujours travailler à une valeur la plus proche possible de son facteur de qualité maximal.

A cet effet, la présente invention concerne, d'abord, une méthode d'accord de la fréquence de résonance d'un circuit résonnant comportant au moins un élément inductif servant d'antenne d'un dispositif d'émission/réception d'un système de transmission en champ proche sur la fréquence d'émission/réception dudit dispositif d'émission/réception. Selon l'invention, ladite méthode est caractérisée en ce qu'elle comprend les étapes suivantes :

- une étape de mesure du déphasage que subit, dans ledit circuit résonnant, le signal modulé à transmettre ou le signal engendré dans ledit élément inductif à la réception de signaux de transmission, et
- une étape de modification de la fréquence de résonance dudit circuit résonnant lorsque ledit déphasage ainsi mesuré n'est pas nul et, ce, de manière à annuler ledit déphasage.

Avantageusement, l'étape de mesure dudit déphasage comprend les sous-étapes suivantes :

- une sous-étape de génération d'un signal de mesure dont la fréquence est égale à la fréquence nominale dudit système de transmission ou à une fréquence voisine de ladite fréquence nominale,
- une sous-étape d'injection dudit signal de mesure à l'entrée dudit circuit résonant,
- une sous-étape de récupération dudit signal de mesure en sortie dudit circuit résonant,
- une sous-étape de mesure du déphasage entre le signal récupéré et ledit signal de mesure,
- une sous-étape de commande dudit circuit résonant en fonction du résultat de l'étape de mesure du déphasage.

La présente invention concerne également un dispositif d'émission/réception d'un système de transmission en champ proche. Ledit dispositif d'émission/réception est du type qui comporte une unité d'émission/réception reliée à un circuit résonant comportant au moins un élément inductif servant d'antenne audit dispositif d'émission/réception pour l'émission d'un signal modulé délivré par ladite unité d'émission/réception ou pour la réception de signaux de transmission.

Selon une caractéristique de la présente invention, ledit dispositif d'émission/réception comporte en outre une unité de mesure de déphasage prévue pour, d'une part, mesurer le déphasage que subit, dans ledit circuit résonant, le signal modulé délivré par ladite unité d'émission/réception ou le signal engendré dans ledit élément inductif à la réception de signaux de transmission et, d'autre part, délivrer un signal de commande à des moyens que comporte ledit circuit résonant pour modifier sa fréquence de résonance, ledit signal de commande tendant à annuler ledit déphasage.

Ladite unité de mesure de déphasage est avantageusement prévue pour :

- générer un signal de mesure ayant une fréquence égale à la fréquence nominale dudit système de transmission ou à une fréquence voisine de ladite fréquence nominale,
- injecter ledit signal de mesure à l'entrée dudit circuit résonant,
- récupérer ledit signal de mesure en sortie dudit circuit résonant,
- mesurer le déphasage entre le signal récupéré et ledit signal de mesure, et
- commander lesdits moyens que comporte ledit circuit résonnant pour modifier sa fréquence de résonance de manière à annuler le déphasage ainsi mesuré.

Avantageusement, pour générer ledit signal de mesure, ladite unité de mesure de déphasage comporte :

- un premier générateur dont la fréquence d'émission est égale à la fréquence nominale dudit système de transmission ou à une fréquence voisine de ladite fréquence nominale,
- un second générateur dont la fréquence d'émission est sensiblement plus basse que celle du premier générateur,
- un modulateur recevant sur ses entrées les signaux générés par lesdits premier et second générateurs et délivrant, en tant que signal de mesure, un signal dont la fréquence d'émission est la somme ou la différence des fréquences d'émission desdits générateurs.

Selon un premier mode de réalisation dudit modulateur, celui-ci est constitué d'un multiplieur recevant sur ses entrées les signaux générés par lesdits premier et second générateurs, d'un filtre dont l'entrée est reliée à la sortie dudit multiplieur, ledit filtre étant prévu pour filtrer l'une des bandes latérales du signal en sortie dudit multiplieur et pour laisser passer l'autre bande latérale, le signal de mesure étant le signal de sortie dudit filtre.

Selon un second mode de réalisation dudit modulateur, celui-ci est constitué d'un premier et d'un second multiplieurs ainsi qu'un premier et un second déphaseurs de π/2, ledit premier multiplieur recevant, sur une entrée, le signal généré par ledit premier générateur et, sur l'autre entrée, le signal généré par ledit second générateur après déphasage dans ledit second déphaseur et ledit second multiplieur recevant, sur une entrée, le signal généré par ledit second générateur et, sur l'autre entrée, le signal généré par ledit premier générateur après déphasage dans ledit premier déphaseur, la sortie de chaque multiplieur étant reliée à l'entrée d'un sommateur ou d'une unité effectuant la différence dont la sortie délivre ledit signal de mesure.

Avantageusement, pour mesurer le déphasage entre ledit signal de mesure et ledit signal de mesure après passage dans ledit circuit résonant, ladite unité de mesure de déphasage comporte :

- une unité de détection recevant, sur une entrée, le signal de mesure après passage dans ledit circuit résonant et, sur l'autre entrée, le signal généré par ledit second générateur et délivrant, sur sa sortie, un signal à la fréquence d'émission dudit second générateur et entaché d'une phase fonction linéaire du déphasage subi par ledit signal de mesure dans ledit circuit résonant, et
- un comparateur de phase recevant, sur une entrée, le signal délivré par ladite unité de détection et, sur l'autre entrée, le signal généré par ledit premier générateur et délivrant, sur sa sortie, ledit signal de commande fonction dudit déphasage.

Dans un premier mode de réalisation de ladite unité de détection, celle-ci est constituée d'un multiplieur recevant sur ses entrées le signal de mesure après passage dans ledit circuit résonant et le signal généré par ledit second générateur et d'un filtre dont l'entrée est reliée à la sortie dudit multiplieur, ledit filtre étant prévu pour filtrer l'une des bandes latérales du signal en sortie dudit multiplieur et pour laisser passer l'autre bande latérale.

Dans un second mode de réalisation de ladite unité de détection, celle-ci est constituée d'un premier et d'un second multiplieurs ainsi qu'un premier et un second déphaseurs de $\pi/2$, ledit premier multiplieur recevant, sur une entrée, le signal de mesure après passage dans ledit circuit résonant et, sur l'autre entrée, le signal généré par ledit second générateur après déphasage dans ledit second déphaseur et ledit second multiplieur recevant, sur une entrée, le signal généré par ledit second générateur et, sur l'autre entrée, le signal mesuré après passage dans ledit circuit résonant après déphasage dans ledit premier déphaseur, la sortie de chaque multiplieur étant reliée à l'entrée d'un sommateur ou d'une unité effectuant la différence.

Avantageusement, pour commander lesdits moyens que comporte ledit circuit résonnant pour modifier sa fréquence de résonance, ladite unité de mesure de déphasage comporte une unité d'asservissement qui reçoit sur son entrée le signal de déphasage et qui délivre un signal de polarisation desdits moyens de commande dudit circuit résonant dont l'amplitude soit telle que ledit déphasage mesuré soit nul.

Avantageusement, ledit circuit résonant comprend une inductance couplée en parallèle avec une capacité, ladite inductance servant d'antenne audit dispositif d'émission/réception.

Alternativement, ledit circuit résonant comprend un transformateur à enroulements symétriques, lesdits enroulements étant couplés en parallèle à ces capacités de même valeur, ledit transformateur servant d'antenne audit dispositif d'émission/réception.

Au moins une capacité dudit circuit résonant est une capacité variable par commande. Ladite capacité est alors constituée de plusieurs capacités qui peuvent, de manière commutable au moyen d'éléments de commutation, être mises en parallèle l'une avec au moins une autre.

Avantageusement, chaque élément de commutation est piloté par un des bits de sortie d'un convertisseur analogique-numérique recevant le signal de déphasage délivré par ladite unité de mesure de déphasage.

Avantageusement, ledit premier générateur est un générateur de signaux sinusoïdaux. De même, ledit second générateur est un générateur de signaux sinusoïdaux.

Alternativement, ledit second générateur est un générateur de séquences pseudo-aléatoire, par exemple, qui utilise pour émettre lesdites séquences un polynôme générateur primitif modulo 2.

Les caractéristiques de la présente invention mentionnées ci-dessus ainsi que d'autres apparaîtront plus clairement à la lecture de la description suivante de modes de réalisation faite en relation avec les dessins joints, parmi lesquels :

La Fig. 1 est une vue schématique d'un système de transmission NFC auquel la présente invention s'applique,

Les Figs. 2a à 2c sont des vues illustrant le principe sur lequel repose la présente invention montrant respectivement un filtre RLC, la courbe de réponse en amplitude et la courbe de réponse en phase d'un tel filtre,

La Fig. 3 est un diagramme illustrant la méthode qui est utilisée par un dispositif d'émission/réception selon la présente invention,

La Fig. 4 est un schéma synoptique d'un premier mode de réalisation d'un dispositif d'émission/réception d'un système de transmission selon la présente invention,

La Fig. 5 est un schéma synoptique d'un second mode de réalisation d'un dispositif d'émission/réception d'un système de transmission selon la présente invention,

La Fig. 6 est un schéma synoptique du second mode de réalisation d'un dispositif d'émission/réception selon la présente invention identique à celui de la Fig. 5, la structure de l'unité de mesure de déphasage étant, dans cette Fig., détaillée,

Les Fig. 7a et 7b sont des vues schématiques d'un premier et d'un second modes de réalisation d'un modulateur équipant une unité de mesure de déphasage d'un dispositif d'émission/réception selon la présente invention,

Les Fig. 8a et 8b sont des vues schématiques d'un premier et d'un second modes de réalisation d'une unité de détection équipant une unité de mesure de déphasage d'un dispositif d'émission/réception selon la présente invention,

Les Fig. 9a et 9b sont des vues schématiques d'un premier et d'un second modes de réalisation d'un comparateur de phase équipant une unité de mesure de déphasage d'un dispositif d'émission/réception selon la présente invention,

La Fig. 10 est un schéma synoptique de la commande d'accord d'un circuit résonnant d'un dispositif d'émission/réception selon la présente invention,

Les Figs. 11a et 11b sont des vues schématiques de variantes de réalisation de dispositifs d'émission/réception conformes aux dispositifs représentés respectivement aux Figs. 4 et 5, et

La Fig. 12 est un schéma synoptique d'un générateur de séquence pseudo-aléatoire pouvant équiper un dispositif d'émission/réception selon la présente invention.

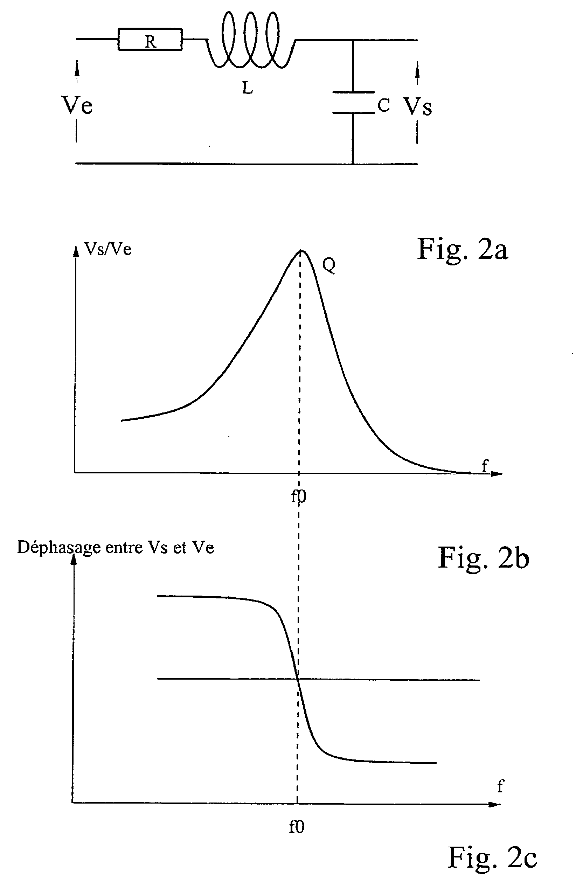

La présente invention est basée sur les caractéristiques de phase que présente un circuit résonnant RLC tel que celui qui est représenté à la Fig. 2a dans laquelle une résistance R est reliée, par une borne, à la source Ve et, par l'autre borne, au point commun entre une inductance L et une capacité C, elles-mêmes reliées en parallèle entre elles et aux bornes desquelles est prélevée la tension de sortie Vs.

Comme on peut le voir sur la courbe de la Fig. 2b, laquelle montre la réponse en amplitude du circuit résonnant RLC en fonction de la fréquence, le maximum d'amplitude est atteint pour une fréquence $f_0$, appelée fréquence de résonance. Le facteur de résonance est noté Q et représente le rapport des amplitudes de sortie et d'entrée du circuit résonant. Comme on peut le voir maintenant sur la courbe de la Fig. 2c, laquelle montre la réponse en phase du circuit résonnant RLC en fonction de la fréquence, à la fréquence de résonance $f_0$, le déphasage introduit par le circuit RLC est nul.

Le principe de la présente invention est basé sur cette constatation. Pour accorder la fréquence de résonance d'un circuit résonant sur une fréquence de référence donnée, en l'occurrence la fréquence d'émission ou de réception des signaux de transmission, encore appelée par la suite fréquence nominale dudit système de transmission, l'invention propose d'effectuer une mesure du déphasage introduit par ce circuit résonant sur lesdits signaux de transmission et de modifier la fréquence de résonance dudit circuit résonant de manière à ce que ce déphasage soit nul.

La présente invention concerne donc une méthode d'accord de la fréquence de résonance d'un circuit résonnant, par exemple du type RLC, dont un élément inductif, par exemple l'inductance L ou un transformateur, est également une antenne d'un dispositif d'émission/réception d'un système de transmission en champ proche, accord sur la fréquence d'émission/réception dudit dispositif d'émission/réception. Ladite méthode comprenant les étapes suivantes :

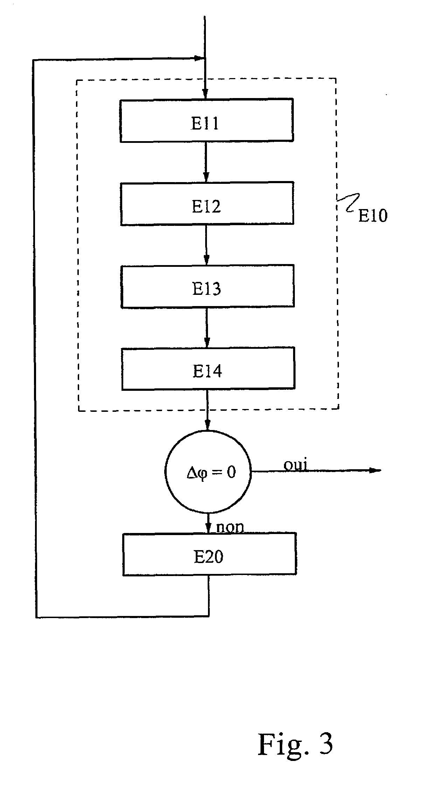

- une étape de mesure du déphasage E10 (voir Fig. 3) que subit, dans le circuit résonant, le signal modulé à transmettre ou le signal engendré dans ledit élément inductif à la réception de signaux de transmission, et
- une étape de modification de la fréquence de résonance dudit circuit résonnant E20 lorsque le déphasage ainsi mesuré n'est pas nul, et ce, de manière à annuler ledit déphasage.

L'étape de mesure dudit déphasage E10 comprend :

- une étape E11 de génération d'un signal de mesure dont la fréquence est égale à la fréquence nominale du système de transmission ou à une fréquence voisine de ladite fréquence nominale,
- une étape E12 d'injection dudit signal de mesure à l'entrée dudit circuit résonnant,
- une étape E13 de récupération dudit signal de mesure en sortie dudit circuit résonnant après passage dans celui-ci,
- une étape E14 de mesure du déphasage entre ledit signal récupéré et ledit signal de mesure.

On décrit maintenant des modes de réalisation de dispositifs d'émission/réception selon la présente invention prévus pour mettre en oeuvre la méthode d'accord qui vient d'être décrite.

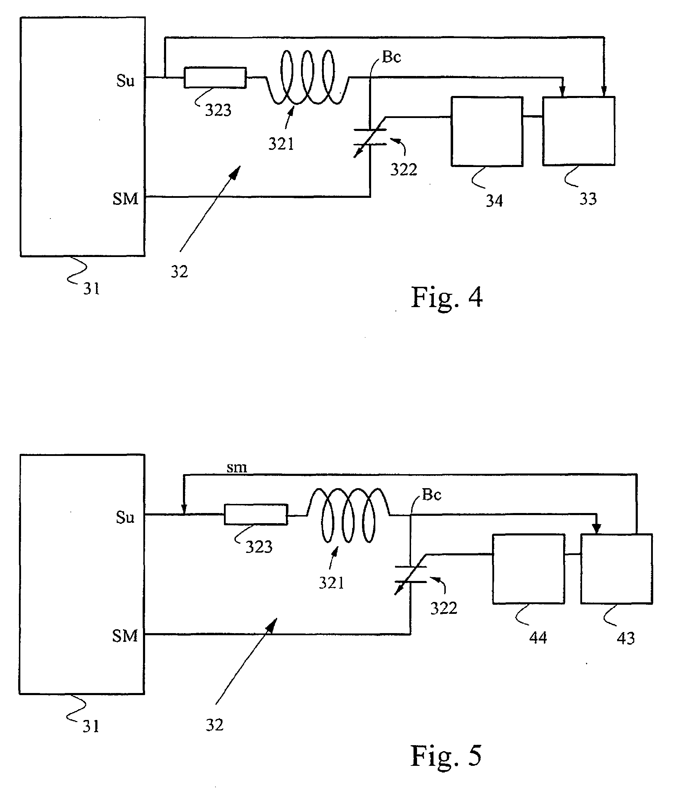

Un dispositif d'émission/réception d'un système de transmission selon la présente invention tel qu'illustré à la Fig. 4 comprend une unité d'émission/réception 31 reliée à un circuit résonant 32 qui est constitué d'une résistance 323 reliée en série à une inductance 321 formant antenne pour le système de transmission et une capacité 322 en parallèle sur l'inductance 321. Une des bornes communes Bc de l'inductance 321 et de la capacité 322 est reliée par l'intermédiaire de la résistance 323 à la borne Su de l'unité d'émission/réception 31 alors que l'autre borne commune est reliée à la masse à laquelle est également reliée l'unité d'émission/réception 31 par sa borne de masse SM. La résistance 323, l'inductance 321 et la capacité 322 présentent respectivement des valeurs telles que le circuit résonnant 32 puisse résonner à la fréquence nominale du système de transmission ou à une fréquence voisine de ladite fréquence nominale. De plus, l'inductance 321 et la capacité 322 sont, l'une et/ou l'autre, variables par application d'une commande issue d'une unité de mesure de déphasage 33 de manière à ce que la fréquence de résonance dudit circuit résonnant 32 puisse varier. En l'occurrence, seule la capacité 322 est variable et commandée.

L'unité de mesure de déphasage 33 mesure le déphasage introduit par le circuit résonnant 32, notamment dans la résistance 323, et modifie la fréquence de résonance dudit circuit résonnant 32 à un point où ledit déphasage tend à être nul, voire est nul. Dans ce cas, comme expliqué ci-dessus, il y a accord de la fréquence de résonance dudit circuit résonnant 32 et de la fréquence réelle d'émission/réception dudit dispositif d'émission/réception et le gain en amplitude du circuit résonant 32 est à son maximum.

Pour ce faire, l'unité de mesure de déphasage 33 a sa sortie qui est reliée à une entrée de commande de l'accord dudit circuit résonnant 32, en l'occurrence l'entrée de commande de la capacité 322 variable et commandée.

Dans un premier mode de réalisation d'un dispositif d'émission selon l'invention, l'unité de mesure de déphasage 33 a une première entrée qui est reliée à la borne Su de l'unité d'émission/réception 31 pour y recevoir le signal modulé par ladite unité d'émission/réception 31 lorsque celle-ci fonctionne en émission et une seconde entrée qui est reliée à la borne commune Bc entre l'inductance 321, la capacité 322 et la résistance 323.

L'unité de mesure de déphasage 33 mesure alors le déphasage entre le signal issu de la borne Su et celui qui est présent sur la borne commune Bc et applique, comme expliqué ci-dessus, une commande au circuit résonnant 32 de manière qu'au moins la valeur de la capacité 322 soit modifiée, c'est-à-dire de manière que la fréquence de résonance du circuit résonnant 32 soit modifiée à un point où ledit déphasage tend à être nul, voire est nul.

Une variante de réalisation est représentée à la Fig. 5. Les mêmes éléments que ceux qui sont représentés à la Fig. 4 portent les mêmes références et ne sont pas de nouveau décrits. L'unité de mesure de déphasage 43 diffère de celle qui est représentée à la Fig. 4 en ce qu'elle est prévue pour injecter un signal de mesure à la fréquence nominale du système de transmission ou à une fréquence voisine dans le circuit résonnant 32, pour mesurer le déphasage que subit ce signal de mesure et pour commander, à l'instar de l'unité de mesure de déphase 33, le circuit résonnant 32, en l'occurrence la capacité 322, de manière à ce que la fréquence du circuit résonnant 32 soit modifiée à un point où ledit déphasage tend à être nul, voire est nul.

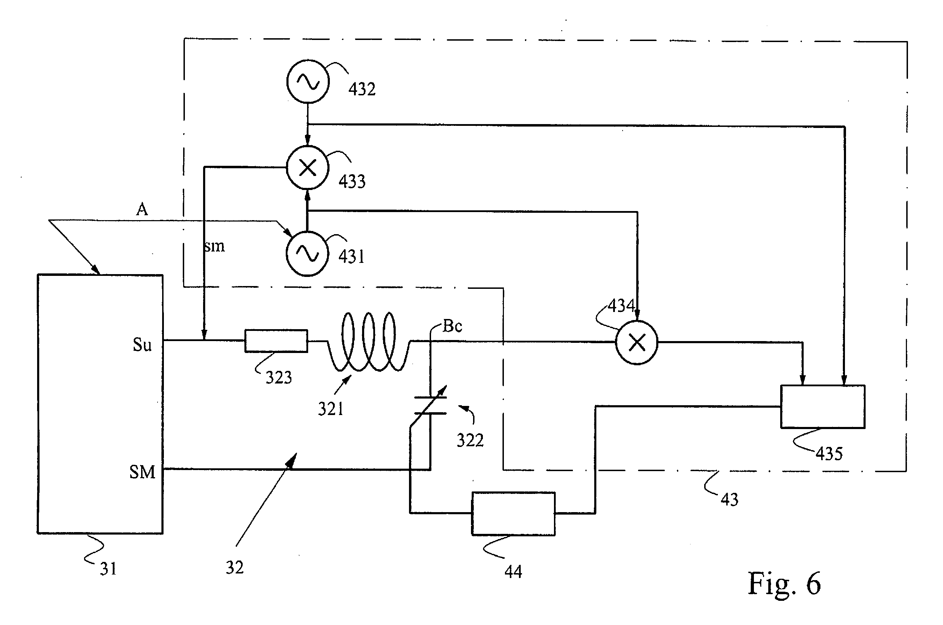

On a représenté à la Fig. 6 un dispositif d'émission/réception tel que celui que l'on a déjà représenté à la Fig. 5 mais où l'on a détaillé l'unité de mesure de déphasage 43 qui seule est maintenant décrite.

Cette unité de mesure de déphasage 43 comporte un générateur 431 d'un signal sinusoïdal à une fréquence de référence $f_{ref}$ qui est, par exemple, égale à la fréquence nominale $f_0$ du système de transmission ou à une fréquence voisine de cette fréquence nominale $f_0$. Pour ce faire, le générateur 431 peut être synchronisé avec l'unité d'émission/réception 11 (synchronisation symbolisée par la flèche A), plus particulièrement avec le générateur interne (non représenté) de cette unité d'émission/réception 11 qui sert à la modulation du signal délivré par elle sur sa sortie Su ou à la démodulation du signal présent sur cette borne Su. Elle comporte également un générateur 432 d'un signal périodique, par exemple de forme sinusoïdale, à fréquence $f_b$ relativement plus basse que la fréquence de référence $f_{ref}$. On considérera par la suite, pour des raisons de simplification de raisonnement, que ces signaux sont sinusoïdaux.

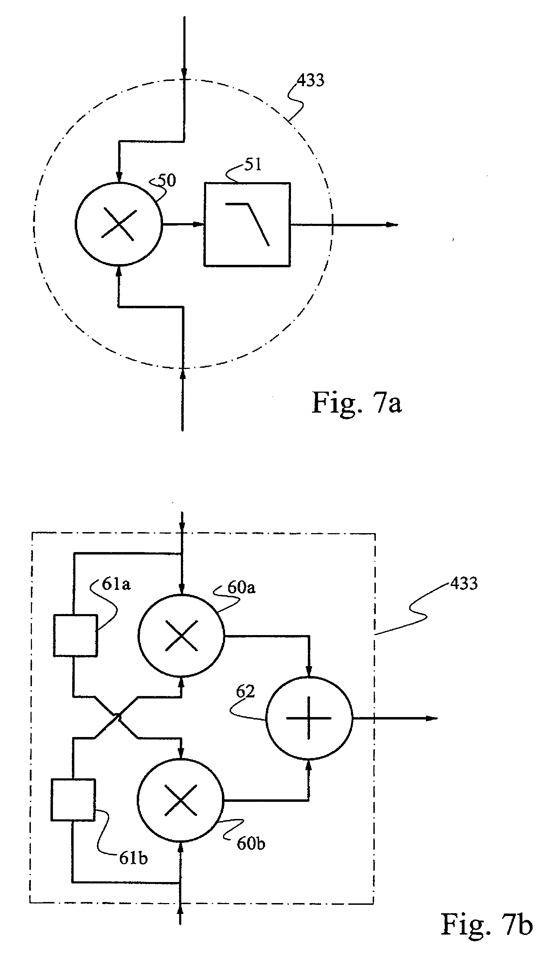

Elle comporte encore un modulateur 433 qui reçoit sur ses deux entrées les signaux sinusoïdaux respectivement générés par les générateurs 431 et 432 et qui délivre un signal sinusoïdal à une fréquence de mesure $f_m$ qui est soit la somme, soit la différence de la fréquence de référence $f_{ref}$ et de la fréquence $f_b$, signal entaché d'une certaine phase dont l'expression sera donnée par la suite. Le modulateur 433 peut être réalisé (voir Fig. 7a) par un multiplieur 50 délivrant deux bandes latérales respectivement centrées sur la fréquence somme $f_{ref} + f_b$ et sur la fréquence différence $f_{ref} - f_b$ et un filtre 51 filtrant l'une des deux bandes latérales et laissant passer l'autre. Le filtre 51 sera un filtre passe-bas pour ne laisser passer que la bande latérale basse et un filtre passe-haut pour ne laisser passer que la bande latérale haute.

On a représenté à la Fig. 7b un autre mode de réalisation d'un modulateur 433. Il comporte un premier multiplieur 60a et un second multiplieur 60b ainsi qu'un premier déphaseur 61a et un second déphaseur 61b, chacun déphasant de π/2. Le premier multiplieur 60a reçoit, sur une entrée, le signal issu d'un premier générateur (par exemple le générateur 432) et, sur l'autre entrée, le signal issu du second générateur (par exemple le générateur 431) après déphasage dans le second déphaseur 61b. Quant au second multiplieur 60b, il reçoit, sur une entrée, le signal issu du second générateur (par exemple le générateur 431) et, sur l'autre entrée, le signal issu du premier générateur (par exemple le générateur 432) après déphasage dans le premier déphaseur 61a. Chaque multiplieur 60a, 60b délivre un signal de sortie à une entrée d'un sommateur 62 dont la sortie constitue la sortie du modulateur 433. On peut montrer que si le signal Sb issu du générateur 432 s'exprime sous la forme :

$$Sb = \sin\left(2\pi\, f_b\, t + \varphi_0\right)$$

où ($\varphi_0$ est une phase arbitraire,
que le signal $S_{ref}$ issu du générateur 431 s'exprime sous la forme :

$$S_{ref} = \cos\left(2\pi\, f_{ref}\, t\right)$$

alors le signal de mesure <u>sm</u> délivré par le modulateur 433 s'exprime sous la forme :

$$sm = \cos\left[2\pi\left(f_{ref} + f_b\right)t + \varphi_0\right]$$

On notera que si le sommateur 62 est remplacé par une unité effectuant la différence entre les signaux présents sur ses entrées respectives, le signal de mesure sm alors délivré par le modulateur 433 s'exprime, au signe près, sous la forme :

$$sm = \cos\left[2\pi\left(f_{ref} - f_b\right)t + \varphi_0\right]$$

Sur la Fig. 6, l'unité de mesure de déphasage 43 comporte encore une unité de détection 434 qui reçoit sur une de ses deux entrées, le signal présent sur la borne commune Bc entre l'inductance 321, le condensateur 322 et la résistance 323 et, sur l'autre entrée, le signal issu du générateur 431 à la fréquence de référence $f_{ref}$. Elle délivre un signal à la fréquence du générateur 432 de fréquence basse $f_b$ entaché d'un déphasage qui sera explicité ci-dessous.

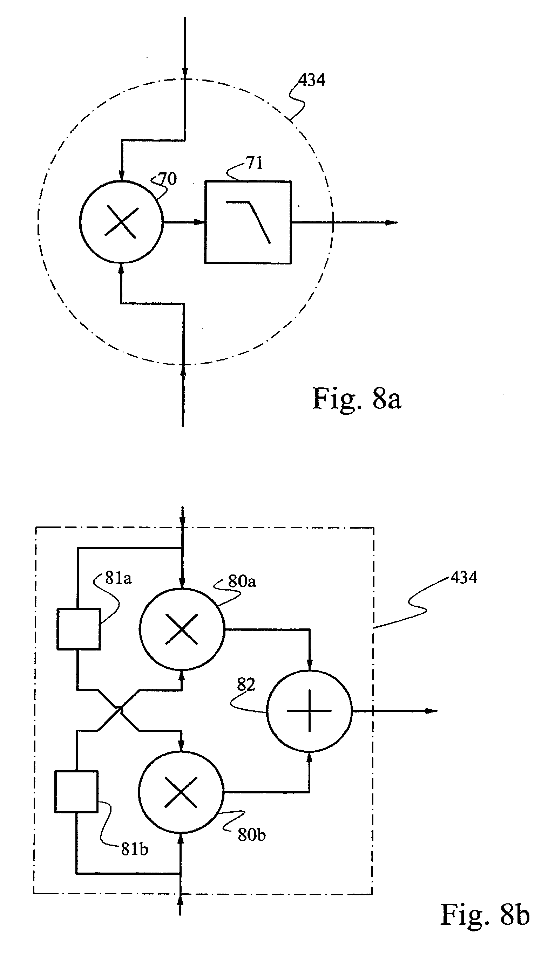

Dans un premier mode de réalisation représenté à la Fig. 8a, l'unité de détection 434 comporte un multiplieur 70 délivrant deux bandes latérales respectivement centrées sur la fréquence somme $f_m + f_{ref}$ et sur la fréquence différence $f_m - f_{ref}$ et un filtre 71 filtrant l'une des deux bandes latérales et laissant passer l'autre.

Dans le cas où le signal de mesure <u>sm</u> a pour fréquence la somme des fréquences $f_{ref}$ et $f_b$, le filtre 71 sera un filtre passe-bas pour ne laisser passer que la fréquence différence, soit la fréquence $(f_{ref} + f_b) - f_{ref} = f_b$. Dans le cas contraire où le signal de mesure <u>sm</u> a pour fréquence la différence des fréquences $f_{ref}$ et $f_b$, le filtre 71 sera un filtre passe-haut pour ne laisser passer que la fréquence somme, soit la fréquence $f_{ref} - (f_{ref} - f_b) = f_b$. On constate que, dans ces deux cas, le signal à la sortie de l'unité de détection 434 a une fréquence égale à la fréquence $f_b$ du générateur 432. Un autre mode de réalisation de l'unité de détection 434 est représenté à la

Fig. 8b. Elle comporte un premier multiplieur 80a et un second multiplieur 80b ainsi qu'un premier déphaseur 81a et un second déphaseur 81b, chacun déphasant de $\pi/2$. Le premier multiplieur 80a reçoit, sur une entrée, le signal issu du générateur 432 à fréquence basse $f_b$ et, sur l'autre entrée, le signal présent sur la borne commune Bc entre l'inductance 321, le condensateur 322 et la résistance 323, après déphasage dans le second déphaseur 81b. Quant au second multiplieur 80b, il reçoit, sur une entrée, le signal présent sur la borne commune Bc et, sur l'autre entrée, le signal issu du générateur 432 après déphasage dans le premier déphaseur 81a. Chaque multiplieur 80a, 80b délivre un signal de sortie à une entrée d'un sommateur 82 ou d'une unité de différence 82 (on verra ci-dessous comment le choix de l'un ou de l'autre doit être opéré) dont la sortie constitue la sortie du modulateur 433.

Dans le cas où le signal de mesure <u>sm</u> a pour fréquence la somme des fréquences $f_{ref}$ et $f_b$, le signal Sb issu du générateur 432 s'exprime sous la forme :

$$Sb = \sin(2\pi\, f_b\, t + \varphi_0)$$

où ($\varphi_0$ est une phase arbitraire,
le signal $S_{Bc}$ présente sur la borne commune Bc s'exprime sous la forme :

$$S_{Bc} = \cos[2\pi\,(f_{ref} + f_b)\,t + \varphi_0 + \varphi_1]$$

alors le signal $S_D$ de sortie de l'unité de détection 434 s'exprime sous la forme :

$$S_D = \cos[2\pi\, f_b\, t + \varphi_0 + \varphi_1]$$

On notera que, pour ce faire, l'unité 82 devra être une unité de différence.

Dans le cas contraire où le signal de mesure

<u>sm</u> a pour fréquence la différence des fréquences $f_{ref}$ et $f_b$, l'unité 82 devra être un sommateur. En effet, on a alors :

$$S_{Bc} = \cos[2\pi\,(f_{ref} - f_b)\,t - \varphi_0 + \varphi_1]$$

et, donc

$$S_D = \cos[2\pi\, f_b\, t + \varphi_0 - \varphi_1]$$

On pourrait montrer que les signaux délivrés par l'unité de détection 434 dans son mode de réalisation de la Fig. 8a s'expriment selon les mêmes expressions.

A la Fig. 6, l'unité de mesure de déphasage 43 comporte encore un comparateur de phase 435 qui reçoit, sur une entrée, le signal délivré par le générateur 432 et, sur l'autre entrée, le signal délivré par l'unité de détection 434. On peut constater que ces signaux sont de même fréquence $f_b$. Il délivre un signal de phase $S_\varphi$ qui est fonction de la différence de phase entre les signaux respectivement présents sur ses entrées.

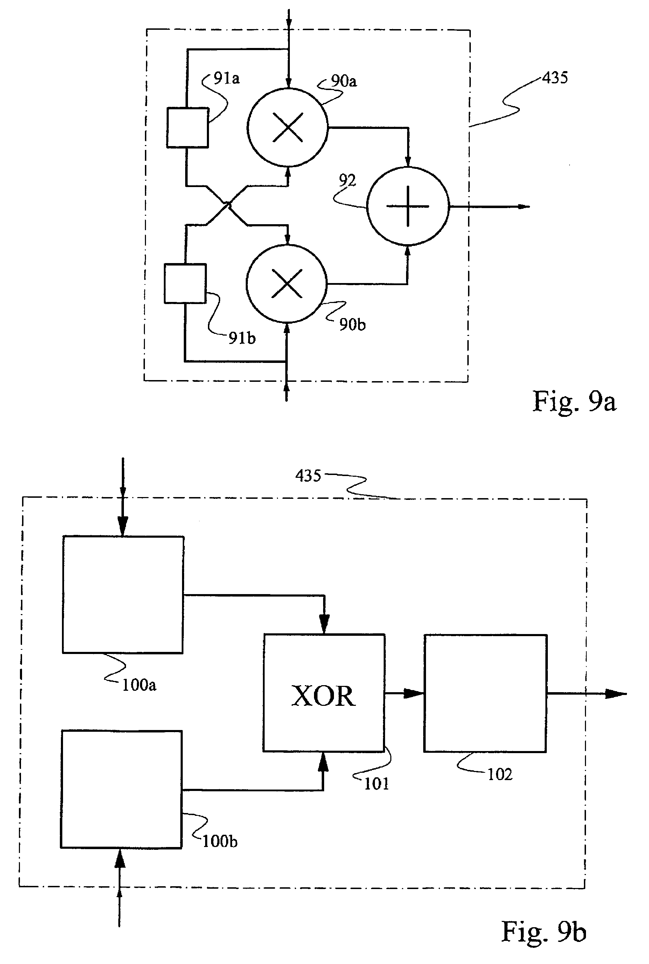

Selon un mode de réalisation représenté à la Fig. 9a, le comparateur de phase 435 reprend la structure du modulateur 433 ou de l'unité de détection 434. Il comprend donc un premier multiplieur 90a et un second multiplieur 90b ainsi qu'un premier déphaseur 91a et un second déphaseur 91b, chacun déphasant de $\pi/2$. Le premier multiplieur 90a reçoit, sur une entrée, le signal issu du générateur 432 à fréquence basse $f_b$ et, sur l'autre entrée, le signal de sortie de l'unité de détection 434 après déphasage dans le second déphaseur 91b. Quant au second multiplieur 90b, il reçoit, sur une entrée, le signal de sortie de l'unité de détection 434 et, sur l'autre entrée, le signal issu du générateur 432 après déphasage dans le premier déphaseur 91a. Chaque multiplieur 90a, 90b délivre un signal de sortie à une entrée d'un sommateur 92 dont la sortie constitue la sortie du comparateur de phase 435.

Le signal Sb issu du générateur 432 s'exprime sous la forme :

$$Sb = \sin(2\pi\, f_b\, t + \varphi_0)$$

et le signal $S_D$ à la sortie de l'unité de détection 434 s'exprime sous la forme :

$$S_D = \cos[2\pi\, f_b\, t + \varphi_0 - \varphi_1]$$

Alors le signal de sortie $S_\varphi$ du comparateur de

phase 435 s'exprime sous la forme :

$$S_\varphi = \sin [\varphi_1]$$

On constate qu'il est directement fonction de la phase ($\varphi$1 qu'a subi le signal de mesure sm dans le circuit résonnant 32.

Un autre mode de réalisation, connu en soi, d'un comparateur de phase 435 qui peut être utilisé en tant que comparateur de phase 435 est représenté à la Fig. 9b. Il comprend deux convertisseurs de forme 100a et 100b qui ont pour fonction essentielle de transformer les signaux sinusoïdaux respectivement issus de l'unité de détection 434 et de l'oscillateur 432 en signaux carrés de même fréquence. Les sorties respectives des convertisseurs 100a et 100b sont délivrées aux entrées d'une porte 101 du type XOR (OU exclusif) qui délivre à chaque période une impulsion dont la largeur est représentative du déphasage entre les deux signaux sinusoïdaux d'entrée. Il comporte encore une unité de valeur moyenne 102 qui détermine la valeur moyenne du signal en sortie de la porte XOR. On montre que la tension en sortie de l'unité de valeur moyenne 102 est proportionnelle à la différence de phase entre les signaux sinusoïdaux aux entrées du comparateur 435.

Si l'on revient sur la Fig. 6, l'unité de mesure de déphasage 43 comporte en outre une unité d'asservissement 436 dont l'entrée est directement reliée à la sortie du comparateur de phase 435 et dont la sortie constitue la sortie de ladite unité de mesure de déphasage 43. L'unité d'asservissement 436 a pour fonction de polariser le circuit résonnant 32 de manière que le signal de déphasage $S_\varphi$ soit nul ou tende vers zéro. L'unité d'asservissement 436 est, par exemple, du type à PID (Proportionnelle/Intégrale/Dérivé).

La sortie de l'unité de mesure de déphasage 43 (par conséquence de l'unité d'asservissement 436) agit sur le circuit résonnant 32. De manière avantageuse, elle agit sur la valeur de la capacité 322 qui est donc variable et commandée.

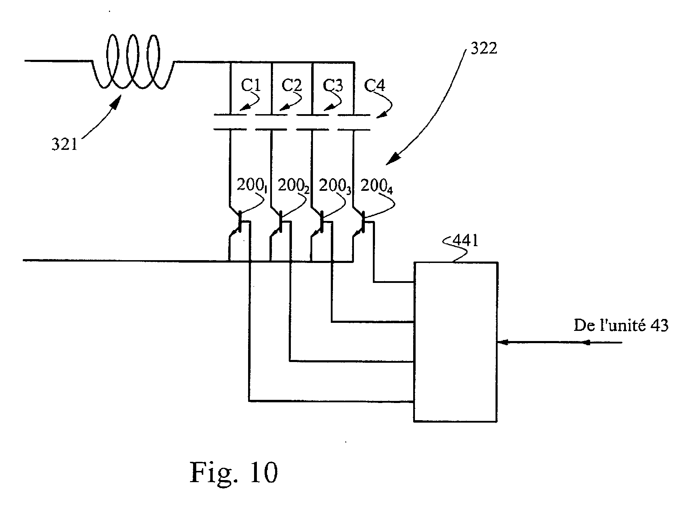

Dans un mode de réalisation représenté à la Fig. 10, le signal délivré par l'unité 43 est fourni à un convertisseur analogique/numérique 200 dont les sorties de bit de poids différents sont respectivement reliées à des commutateurs de capacités $201_1$ à $201_N$ (à la Fig. 10, N = 4) ici constitués (donnés à titre d'exemple) de transistors dont l'émetteur est relié à la masse, le collecteur à la capacité $C_j$ (j= 1 à N) correspondante, la base recevant le bit correspondant du convertisseur 200. Les capacités $C_1$ à $C_N$ ont des valeurs en rapport au poids du bit qui les commute : par exemple, celle de poids le plus faible, une valeur C ; celle de poids j, une valeur de $2^j$ x C et celle de poids le plus fort $2^N$ x C, N étant le nombre total de bits du convertisseur 200.

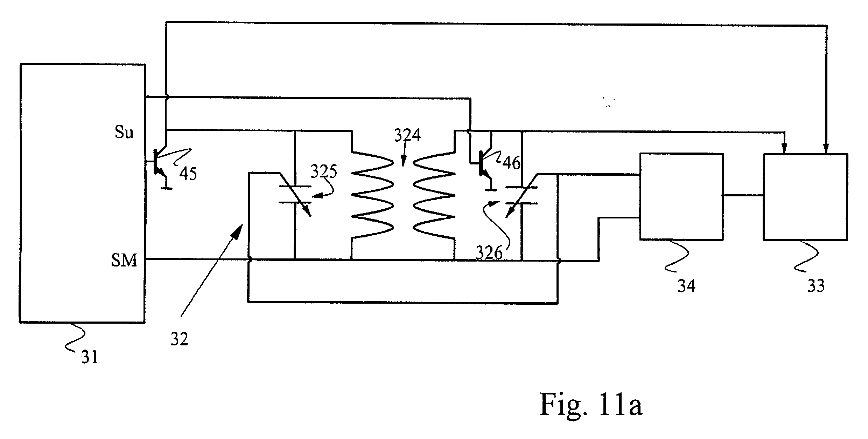

On a représenté à la Fig. 11a un autre mode de réalisation d'un dispositif d'émission/réception selon l'invention qui diffère de celui qui est représenté à la Fig. 4 en ce que le circuit résonnant 32 est constitué d'un transformateur symétrique 324, chaque enroulement dudit transformateur 324 étant relié à une capacité 325, 326. De plus, le signal utile Su est fourni au circuit résonnant 32 au moyen de deux transistors 45 et 46 dont les émetteurs sont reliés à la masse, les collecteurs respectivement aux bornes communes entre les enroulements du transformateur 324 et les capacités 325 et 326 et les bases à des sorties de l'unité d'émission/réception 31 délivrant, quand elle fonctionne en émission, le signal utile Su.

Les capacités 325 et 326 sont avantageusement des capacités variables et commandées. Chacune d'elles peut être constituée de plusieurs capacités qui peuvent être, de manière commutable, mises en parallèle l'une avec au moins une autre, à l'instar de ce qui est montré à la Fig. 10.

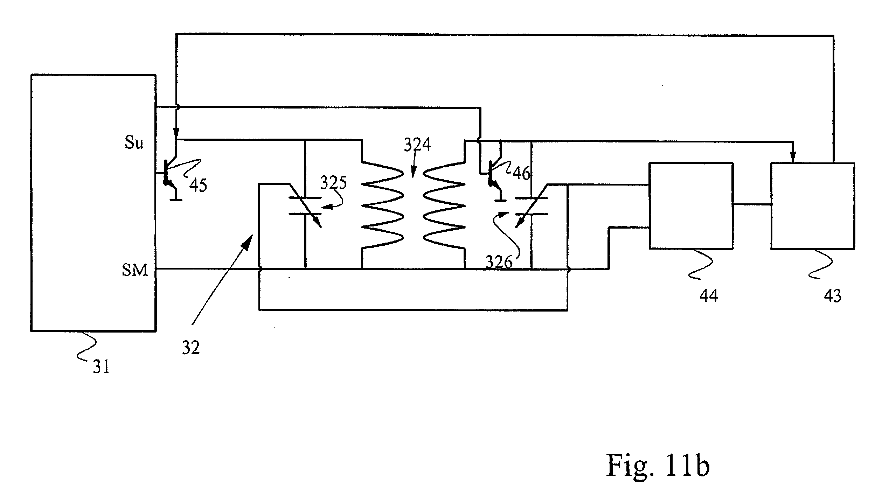

On a représenté à la Fig. 11b un autre mode de réalisation d'un dispositif d'émission selon l'invention, qui diffère de celui qui est représenté à la Fig. 5 en ce que le circuit résonnant 32 a même constitution que celui qui est montré à la Fig. 11a.

Afin de réduire le niveau de perturbation que peut engendrer la mesure du déphasage, le générateur 432 de l'unité de mesure de déphasage 43 n'est plus un générateur de signaux sinusoïdaux, mais un générateur de séquence pseudo-aléatoire. Un tel générateur de séquence pseudo-aléatoire utilise par exemple un polynôme générateur primitif modulo 2. Si la séquence est longue, l'écart type est grand et le signal produit par un tel générateur peut s'apparenter à un bruit blanc. Néanmoins, dans le choix de la longueur de la séquence, on tiendra compte aussi du fait qu'une séquence longue implique un étalement du spectre émis par le dispositif d'émission, ce qu'il est préférable d'éviter.

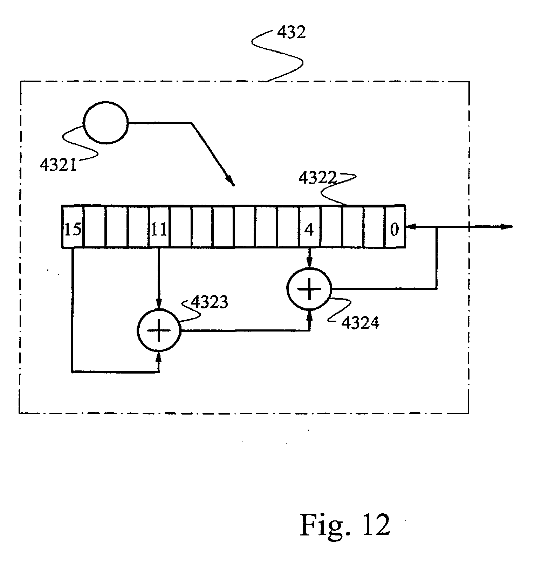

On a représenté à la Fig. 12 un mode de réalisation particulier d'un tel générateur de séquence pseudo-aléatoire. Il est essentiellement constitué d'un registre à décalage 4322 piloté par une horloge 4321 dont chaque case peut prendre la valeur 0 ou 1 selon son état. Il comporte encore au moins un sommateur (en l'occurrence, les sommateurs 4323 et 4324). Le sommateur 4323 a ses deux entrées qui sont respectivement reliées à deux cases du registre 4322, en l'occurrence les cases 11 et 15. Quant au sommateur 4324, il a une entrée qui est reliée à une des cases du registre 4322, en l'occurrence la case 4, une autre entrée reliée à la sortie du sommateur 4323 et sa sortie reliée à la sortie du registre 4322 formant ainsi la sortie dudit générateur 432, sortie reliée également à l'entrée du registre 4322, entrée constituée par la case 0. Un tel générateur 432 génère une séquence dont le polynôme générateur peut s'écrire :

$$X^{15} + X^{11} + X^4 + X^0$$

Une telle séquence a une période de $2^{15} - 1$ temps d'horloge.

On pourrait également choisir une séquence dont le polynôme générateur serait :

$$X^5 + X^2 + 1$$

dont la période serait alors de $2^5 - 1$ temps d'horloge.

On notera que la phase du signal de mesure <u>sm,</u> après traversée du circuit résonnant 32, n'est plus constante mais qu'elle est également étalée dans le temps, d'une part, par le produit de convolution avec la séquence pseudo-aléatoire et, d'autre part, par la fonction de transfert du circuit résonnant 32. La phase est évaluée par des moments statistiques, principalement la moyenne.


**Revendications**

1. Méthode d'accord de la fréquence de résonance d'un circuit résonnant (12; 22; 32) comportant au moins un moyen d'accord adaptif (322) et un élément inductif (121; 221; 321; 324) servant d'antenne d'un dispositif d'émission/réception (10, 20) d'un système de transmission en champ proche sur la fréquence d'émission/réception dudit dispositif d'émission/réception (10, 20), **caractérisée en ce qu'**elle comprend les étapes suivantes :

    - une étape de réception d'un signal modulé,
    - une étape de mesure du déphasage (E10), dans ledit circuit résonnant (12; 22; 32), d'un signal engendré dans ledit élément inductif à la réception du signal modulé, et
    - une étape (E20) de modification de la fréquence de résonance dudit circuit résonnant (12; 22; 32) lorsque ledit déphasage ainsi mesuré n'est pas nul et, ce, de manière à annuler ledit déphasage.

2. Méthode d'accord selon la revendication 1, comprenant en outre les étapes suivantes :

    - une étape de mesure du déphasage (E10) d'un signal à transmettre, et
    - une étape (E20) de modification de la fréquence de résonance dudit circuit résonnant (12; 22; 32) lorsque ledit déphasage ainsi mesuré n'est pas nul et, ce, de manière à annuler ledit déphasage.

3. Méthode d'accord selon la revendication 1 ou 2, dans laquelle l'étape de mesure dudit déphasage (E10) comprend les étapes suivantes :

    - une étape (E11) de génération d'un signal de mesure dont la fréquence est égale à la fréquence nominale dudit système de transmission ou à une fréquence voisine de ladite fréquence nominale,
    - une étape (E12) d'injection dudit signal de mesure à l'entrée dudit circuit résonant,
    - une étape (E13) de récupération dudit signal de mesure en sortie dudit circuit résonant,
    - une étape (E14) de mesure du déphasage entre le signal récupéré et ledit signal de mesure,
    - une étape de commande dudit circuit résonant en fonction du résultat de l'étape (E14) de mesure du déphasage.

4. Dispositif d'émission/réception (10, 20), d'un système de transmission en champ proche, ledit dispositif d'émission/réception comportant une unité d'émission/réception (31) reliée à un circuit résonant (12; 22; 32) comportant au moins un moyen d'accord adaptif (322) et un élément inductif (121; 221; 321; 324) servant d'antenne audit dispositif d'émission/réception, **caractérisé en ce que** ledit dispositif d'émission/réception (10, 20) comportant en outre un moyen de mesure de déphasage (33; 43) pour mesurer le déphasage, dans ledit circuit résonant, d'un signal engendré dans ledit élément inductif à la réception d'un signal modulé et pour délivrer un signal de commande audit circuit résonant (12; 22; 32) pour modifier sa fréquence de résonance, ledit signal de commande tendant à annuler ledit déphasage.

5. Dispositif d'émission/réception d'un système de transmission en champ proche selon la revendication 4, dans lequel ledit moyen de mesure de déphasage (33; 43) est en outre destiné à mesurer un déphasage d'un signal à transmettre, et ledit dispositif d'émission/réception (10, 20) est configuré pour fournir un signal de commande audit circuit résonant (12; 22; 32) pour modifier sa fréquence de résonance, dans lequel ledit signal de commande tend à annuler ledit déphasage.

6. Dispositif d'émission/réception d'un système de transmission en champ proche selon la revendication 4 ou 5, dans lequel ledit moyen de mesure de déphasage (33; 43) est prévu pour :

    - générer un signal de mesure ayant une fréquence égale à la fréquence nominale dudit système de transmission ou à une fréquence voisine de ladite fréquence nominale,
    - injecter ledit signal de mesure à l'entrée dudit circuit résonant,
    - récupérer ledit signal de mesure en sortie dudit circuit résonant,
    - mesurer le déphasage entre le signal récupéré et ledit signal de mesure, et

- commander lesdits moyens que comporte ledit circuit résonnant pour modifier sa fréquence de résonance de manière à annuler le déphasage ainsi mesuré.

**7.** Dispositif d'émission/réception d'un système de transmission en champ proche selon la revendication 6, dans lequel, pour générer ledit signal de mesure, ledit moyen de mesure de déphasage (33; 43) comporte :

    - un premier générateur (431) dont la fréquence d'émission est égale à la fréquence nominale dudit système de transmission ou à une fréquence voisine de ladite fréquence nominale,
    - un second générateur (432) dont la fréquence d'émission est sensiblement plus basse que celle du premier générateur (431),
    - un modulateur (433) recevant sur ses entrées les signaux générés par lesdits premier et second générateurs (431 et 432) et délivrant, en tant que signal de mesure, un signal dont la fréquence d'émission est la somme ou la différence des fréquences d'émission desdits générateurs (431 et 432).

**8.** Dispositif d'émission/réception d'un système de transmission en champ proche selon la revendication 7, dans lequel ledit modulateur (433) est constitué d'un multiplieur (50) recevant sur ses entrées les signaux générés par lesdits premier et second générateurs (431 et 432), d'un filtre (51) dont l'entrée est reliée à la sortie dudit multiplieur (50), ledit filtre (51) étant prévu pour filtrer l'une des bandes latérales du signal en sortie dudit multiplieur (50) et pour laisser passer l'autre bande latérale, le signal de mesure étant le signal de sortie dudit filtre (51).

**9.** Dispositif d'émission/réception d'un système de transmission en champ proche selon la revendication 7, dans lequel ledit modulateur (433) est constitué d'un premier et d'un second multiplieurs (6oa et 6ob) ainsi qu'un premier et un second déphaseurs (61a et 61b) de $\pi/2$, ledit premier multiplieur (60a) recevant, sur une entrée, le signal généré par ledit premier générateur (431) et, sur l'autre entrée, le signal généré par ledit second générateur (432) après déphasage dans ledit second déphaseur (61b) et ledit second multiplieur (60b) recevant, sur une entrée, le signal généré par ledit second générateur (432) et, sur l'autre entrée, le signal généré par ledit premier générateur (431) après déphasage dans ledit premier déphaseur (61a), la sortie de chaque multiplieur (60a, 60b) étant reliée à l'entrée d'un sommateur (62) ou d'une unité effectuant la différence dont la sortie délivre ledit signal de mesure.

**10.** Dispositif d'émission/réception d'un système de transmission en champ proche selon une des revendications 7 à 9, dans lequel, pour mesurer le déphasage entre ledit signal de mesure et ledit signal de mesure après passage dans ledit circuit résonant, ledit moyen de mesure de déphasage comporte :

    - une unité de détection (434) recevant, sur une entrée, le signal de mesure après passage dans ledit circuit résonant (12; 22; 32) et, sur l'autre entrée, le signal généré par ledit second générateur (431) et délivrant, sur sa sortie, un signal à la fréquence d'émission dudit second générateur (432) et entaché d'une phase fonction linéaire du déphasage subi par ledit signal de mesure dans ledit circuit résonant, et
    - un comparateur de phase (435) recevant, sur une entrée, le signal délivré par ladite unité de détection (434) et, sur l'autre entrée, le signal généré par ledit premier générateur (432) et délivrant, sur sa sortie, ledit signal de commande fonction dudit déphasage.

**11.** Dispositif d'émission/réception d'un système de transmission en champ proche selon la revendication 10, dans lequel ladite unité de détection (434) est constituée d'un multiplieur (70) recevant sur ses entrées le signal de mesure après passage dans ledit circuit résonant (12; 22; 32) et le signal généré par ledit second générateur (431) et d'un filtre (71) dont l'entrée est reliée à la sortie dudit multiplieur (70), ledit filtre (71) étant prévu pour filtrer l'une des bandes latérales du signal en sortie dudit multiplieur (70) et pour laisser passer l'autre bande latérale.

**12.** Dispositif d'émission/réception d'un système de transmission en champ proche selon la revendication 10, dans lequel ladite unité de détection (434) est constituée d'un premier et d'un second multiplieurs (80a et 80b) ainsi qu'un premier et un second déphaseurs (91a et 91b) de $\pi/2$, ledit premier multiplieur (80a) recevant, sur une entrée, le signal de mesure après passage dans ledit circuit résonant (12; 22; 32) et, sur l'autre entrée, le signal généré par ledit second générateur (431) après déphasage dans ledit second déphaseur (81b) et ledit second multiplieur (80b) recevant, sur une entrée, le signal généré par ledit second générateur (431) et, sur l'autre entrée, le signal mesuré après passage dans ledit circuit résonant (12; 22; 32) après déphasage dans ledit premier déphaseur (81a), la sortie de chaque multiplieur (80a; 80b) étant reliée à l'entrée d'un sommateur (82) ou d'une unité effectuant la différence.

**13.** Dispositif d'émission/réception d'un système de transmission en champ proche selon une des revendications 6 à 12, dans lequel, pour commander lesdits moyens que comporte ledit circuit résonnant (12;

22; 32) pour modifier sa fréquence de résonance, ldit moyen de mesure de déphasage (43) comporte une unité d'asservissement (436) qui reçoit sur son entrée le signal de déphasage et qui délivre un signal de polarisation desdits moyens de commande dudit circuit résonant (12; 22; 32) dont l'amplitude est telle que ledit déphasage mesuré soit nul.

**14.** Dispositif d'émission/réception d'un système de transmission en champ proche selon une des revendications 4 à 13, dans lequel ledit circuit résonant (12; 22; 32) comprend une inductance couplée en parallèle avec une capacité, ladite inductance servant d'antenne audit dispositif d'émission/réception.

**15.** Dispositif d'émission/réception d'un système de transmission en champ proche selon une des revendications 4 à 13, dans lequel ledit circuit résonant comprend un transformateur à enroulements symétriques (324), lesdits enroulements étant couplés en parallèle à ces capacités de même valeur, ledit transformateur servant d'antenne audit dispositif d'émission/réception.

**16.** Dispositif d'émission/réception d'un système de transmission en champ proche selon la revendication 14 ou 15, dans lequel ladite ou chaque capacité est une capacité variable par commande.

**17.** Dispositif d'émission/réception d'un système de transmission en champ proche selon la revendication 16, dans lequel ladite ou chaque capacité est constituée de plusieurs capacités (C1 à Cn) qui peuvent, de manière commutable au moyen d'éléments de commutation (2001 à 200n), être mises en parallèle l'une avec au moins une autre.

**18.** Dispositif d'émission/réception d'un système de transmission en champ proche selon la revendication 17, dans lequel chaque élément de commutation est piloté par un des bits de sortie d'un convertisseur analogique-numérique (200) recevant le signal de déphasage délivré par ledit moyen de mesure de déphasage (43).

**19.** Dispositif d'émission/réception d'un système de transmission en champ proche selon une des revendications 7 à 18, dans lequel ledit premier générateur (431) est un générateur de signaux sinusoïdaux.

**20.** Dispositif d'émission/réception d'un système de transmission en champ proche selon une des revendications 7 à 19, dans lequel ledit second générateur (432) est un générateur de signaux sinusoïdaux.

**21.** Dispositif d'émission/réception d'un système de transmission en champ proche selon une des revendications 7 à 19, dans lequel ledit second générateur est un générateur de séquences pseudo-aléatoire.

**22.** Dispositif d'émission/réception d'un système de transmission en champ proche selon la revendication 21, dans lequel ledit générateur de séquences pseudo-aléatoire utilise pour émettre lesdites séquences un polynôme générateur primitif modulo 2.

**Claims**

**1.** Method for tuning the resonant frequency of a resonant circuit (12; 22; 32) comprising at least one adaptive tuning means (322) and an inductive element (121; 221; 321; 324) serving as an antenna of a transmission/reception device (10, 20) of a near-field transmission system on the transmission/reception frequency of said transmission/reception device (10, 20), **characterized in that** it comprises the following steps:

- a step of receiving a modulated signal,
- a step of measuring the phase shift (E10) of a signal generated in said inductive element upon reception of the modulated signal in said resonant circuit (12; 22; 32), and
- a step (E20) of modifying the resonant frequency of said resonant circuit (12; 22; 32) when said phase shift measured in this manner is not null, so as to cancel said phase shift.

**2.** Method of tuning according to claim 1 further comprising the following steps:

- a step of measuring the phase shift (E10) of a signal to be transmitted, and
- a step (E20) of modifying the resonant frequency of said resonant circuit (12; 22; 32) when said phase shift measured in this manner is not null, so as to cancel said phase shift.

**3.** Method of tuning according to claim 1 or 2 wherein the step of measuring said phase shift (E10) comprises the following steps:

- a step (E11) of generating a measurement signal, the frequency of which is equal to the nominal frequency of said transmission system or to a frequency in the neighborhood of said nominal frequency,
- a step (E12) of injecting said measurement signal to the input of said resonant circuit,
- a step (E13) of retrieving said measurement signal at the output of said resonant circuit,
- a step (E14) of measuring the phase shift between the retrieved signal and said measurement signal,
- a step of controlling said resonant circuit as a function of the result of the step (E14) of measuring the phase shift.

4. Transmission/reception device (10, 20) of a near-field transmission system, said transmission/reception device comprising a transmission/reception unit (31) connected to a resonant circuit (12; 22; 32) comprising at least one adaptive tuning means (322) and an inductive element (121; 221; 321; 324) serving as an antenna to said transmission/reception device, **characterized in that** said transmission/reception device (10, 20) further comprises a phase shift measuring means (33; 43) for measuring a phase shift of a signal generated in said inductive element upon reception of a modulated signal in said resonant circuit (12; 22; 32), and for delivering a control signal to said resonant circuit (12; 22; 32) for modifying its resonant frequency, wherein said control signal tends to cancel said phase shift.

5. Transmission/reception device of a near-field transmission system according to claim 4, wherein said phase shift measuring means (33; 43) further measures a phase shift of a signal to be transmitted, and said transmission/reception device (10, 20) is configured for delivering a control signal to said resonant circuit (12; 22; 32) for modifying its resonant frequency, wherein said control signal tends to cancel said phase shift.

6. Transmission/reception device of a near-field transmission system according to claim 4 or 5, wherein said phase shift measuring means (33; 43) is provided for:

   - generating a measurement signal having a frequency equal to the nominal frequency of said transmission system or to a frequency in the neighborhood of said nominal frequency,
   - injecting said measurement signal to the input of said resonant circuit,
   - retrieving said measurement signal at the output of said resonant circuit,
   - measuring the phase shift between the retrieved signal and said measurement signal, and
   - controlling said means that said resonant circuit comprises for modifying its resonant frequency, so as to cancel the phase shift measured in this manner.

7. Transmission/reception device of a near-field transmission system according to claim 6, wherein said phase shift measuring means (33; 43) comprises, for generating said measurement signal:

   - a first generator (431), the transmission frequency of which is equal to the nominal frequency of said transmission system or to a frequency in the neighborhood of said nominal frequency,
   - a second generator (432), the transmission frequency of which is essentially lower than that of the first generator (431),
   - a modulator (433) receiving at its inputs the signals generated by said first and second generators (431 and 432) and delivering as a measurement signal a signal, the transmission frequency of which is the sum or the difference of the transmission frequencies of said generators (431 and 432).

8. Transmission/reception device of a near-field transmission system according to claim 7, wherein said modulator (433) consists of a multiplier (50) receiving at its inputs the signals generated by said first and second generators (431 and 432), a filter (51), the input of which is connected to the output of said multiplier (50), said filter (51) being provided for filtering one of the side bands of the signal at the output of said multiplier (50) and for passing the other side band, wherein the measurement signal is the output signal of said filter (51).

9. Transmission/reception device of a near-field transmission system according to claim 7, wherein said modulator (433) consists of a first and second multiplier (60a and 60b), as well as a first and second $\pi/2$ phase-shifter (61a and 61b), wherein said first multiplier (60a) receives at one input the signal generated by said first generator (431) and, at the other input, the signal generated by said second generator (432) after phase-shifting in said second phase-shifter (61b), and said second multiplier (60b) receives at one input the signal generated by said second generator (432) and, at the other input, the signal generated by said first generator (431) after phase-shifting in said first phase-shifter (61a), wherein the output of each multiplier (60a, 60b) is connected to the input of an adder (62) or to a unit making the difference, the output of which delivering said measurement signal.

10. Transmission/reception device of a near-field transmission system according to one of claims 7 to 9, wherein said phase shift measuring means comprises, for measuring the phase shift between said measurement signal and said measurement signal after passing through the resonant circuit:

    - a detection unit (434) receiving at an input the measurement signal after passing in said resonant circuit (12; 22; 32) and, at the other input, the signal generated by said second generator (431) and delivering, at its output, a signal at the transmission frequency of said second generator (432) and having a phase that is a linear function of the phase shift undergone by said measurement signal in said resonant circuit, and
- a phase comparator (435) receiving at an input the signal delivered by said detection unit (434) and, on the other input, the signal generated by said first generator (432) and delivering at its output said control signal that is a function of said phase shift.

11. Transmission/reception device of a near-field transmission system according to claim 10, wherein said detection unit (434) consists of a multiplier (70) receiving at its inputs the measurement signal after passing through said resonant circuit (12; 22; 32) and the signal generated by said second generator (431), and a filter (71), the input of which is connected to the output of said multiplier (70), said filter (71) being provided for filtering one of the side bands of the output signal of said multiplier (70) and for passing the other side band.

12. Transmission/reception device of a near-field transmission system according to claim 10, wherein said detection unit (434) consists of a first and second multiplier (80a and 80b), as well as a first and second $\pi/2$ phase-shifter (91a and 91b), wherein said first multiplier (80a) receives at one input the measurement signal after passing through said resonant circuit (12; 22; 32) and, at the other input, the signal generated by said second generator (431) after phase shifting in said second phase-shifter (81b) and said second multiplier (80b) receives at one input the signal generated by said second generator (431) and, at the other input, the signal measured after passing through said resonant circuit (12; 22; 32) after phase shifting in said first phase-shifter (81a), the output of each multiplier (80a; 80b) being connected to the input of an adder (82) or a unit making the difference.

13. Transmission/reception device of a near-field transmission system according to one of claims 6 to 12, wherein said phase shift measuring means (43) comprises, for controlling said means that said resonant circuit (12; 22; 32) comprises for modifying its resonant frequency, a controlling unit (436) which receives at its input the phase shift signal and delivers a polarization signal of said control means of said resonant circuit (12; 22; 32), the amplitude of which is such that said measured phase shift is null.

14. Transmission/reception device of a near-field transmission system according to one of claims 4 to 13, wherein said resonant circuit (12; 22; 32) comprises an inductor that is coupled in parallel with a capacitor, said inductor serving as an antenna to said transmission/reception device.

15. Transmission/reception device of a near-field transmission system according to one of claims 4 to 13, wherein said resonant circuit comprises a transformer with symmetrical windings (324), said windings being coupled in parallel to those capacitors having the same value, wherein said transformer serves as an antenna to said transmission/reception device.

16. Transmission/reception device of a near-field transmission system according to claim 14 or 15, wherein said capacitor or each capacitor is a variable controlled capacitor.

17. Transmission/reception device of a near-field transmission system according to claim 16, wherein said capacitor or each capacitor consists of several capacitors (C1 to Cn), wherein one of which can be put in parallel with at least one other, in a commutable manner or using commuting elements (2001 to 200n).

18. Transmission/reception device of a near-field transmission system according to claim 17, wherein each commuting element is driven by one of the output bits of an analog/digital converter (200) receiving the phase shift signal delivered by said phase shift measuring means (43).

19. Transmission/reception device of a near-field transmission system according to one of claims 7 to 18, wherein said first generator (431) is a generator of sinusoidal signals.

20. Transmission/reception device of a near-field transmission system according to one of claims 7 to 19, wherein said second generator (432) is a generator of sinusoidal signals.

21. Transmission/reception device of a near-field transmission system according to one of claims 7 to 19, wherein said second generator is a generator of pseudo-random sequences.

22. Transmission/reception device of a near-field transmission system according to claim 21, wherein said generator of pseudo-random sequences uses a modulo 2 primitive generating polynom for transmitting said sequences.

**Patentansprüche**

1. Verfahren zum Abstimmen der Resonanzfrequenz eines Resonanzkreises (12; 22; 32), der mindestens ein adaptives Abstimmungsmittel (322) und ein induktives Element (121; 221; 321; 324) umfasst, das als Antenne einer Sende-/Empfangsvorrichtung (10, 20) eines Nahfeld-Übertragungssystems auf der Sende-/Empfangsfrequenz der Sende-/Empfangsvorrichtung (10, 20) dient, **dadurch gekennzeichnet, dass** es die folgenden Schritte umfasst:

- einen Schritt des Empfangens eines modulierten Signals,
- einen Schritt des Messens der Phasenverschiebung (E10), im Schwingkreis (12; 22; 32), eines beim Empfang des modulierten Signals, im induktiven Element erzeugten Signals, und
- einen Schritt (E20) des Modifizierens der Resonanzfrequenz des Schwingkreises (12; 22; 32), wenn die so gemessene Phasenverschiebung nicht Null ist, und zwar so, dass die Phasenverschiebung annulliert wird.

2. Verfahren zum Abstimmen nach Anspruch 1, weiterhin umfassend die folgenden Schritte:

- einen Schritt des Messens der Phasenverschiebung (E10) eines zu übertragenden Signals, und
- einen Schritt (E20) des Modifizierens der Resonanzfrequenz des Schwingkreises (12; 22; 32), wenn die so gemessene Phasenverschiebung nicht Null ist, und zwar so, dass die Phasenverschiebung annulliert wird.

3. Verfahren zum Abstimmen nach Anspruch 1 oder 2, bei welchem der Schritt des Messens der Phasenverschiebung (E10) die folgenden Schritte umfasst:

- einen Schritt (E11) des Erzeugens eines Messsignals, dessen Frequenz der Nennfrequenz des Übertragungssystems oder einer der Nennfrequenz benachbarten Frequenz gleich ist,
- einen Schritt (E12) des Eingebens des Messsignals an den Eingang des Schwingkreises,
- einen Schritt (E13) des Erfassens des Messsignals am Ausgang des Schwingkreises,
- einen Schritt (E14) des Messens der Phasenverschiebung zwischen dem erfassten Signal und dem Messsignal,
- einen Schritt des Steuerns des Schwingkreises abhängig vom Ergebnis des Schritts (E14) des Messens der Phasenverschiebung.

4. Sende-/Empfangsvorrichtung (10, 20) eines Nahfeld-Übertragungssystems, bei welcher die Sende-/Empfangsvorrichtung eine Sende-/Empfangseinheit (31) umfasst, die mit einem Schwingkreis (12; 22; 32) verbunden ist, der mindestens ein adaptives Abstimmungsmittel (322) und ein induktives Element (121; 221; 321; 324) umfasst, das als Antenne der Sende-/Empfangsvorrichtung dient, **dadurch gekennzeichnet, dass** die Sende-/Empfangsvorrichtung (10, 20) weiterhin ein Phasenverschiebungsmessungsmittel (33; 43) zum Messen der Phasenverschiebung, im Schwingkreis, eines beim Empfang eines modulierten Signals, im induktiven Element erzeugten Signals, und zum Ausgeben eines Steuersignals an den Schwingkreis (12; 22; 32) zum Modifizieren seiner Resonanzfrequenz umfasst, wobei das Steuersignal dazu neigt, die Phasenverschiebung zu annullieren.

5. Sende-/Empfangsvorrichtung eines Nahfeld-Übertragungssystems nach Anspruch 4, bei welcher das Phasenverschiebungsmessungsmittel (33; 43) weiterhin konfiguriert ist, eine Phasenverschiebung eines zu übertragenden Signals zu messen, und die Sende-/Empfangsvorrichtung (10, 20) konfiguriert ist, um dem Schwingkreis (12; 22; 32) ein Steuersignal zum Modifizieren seiner Resonanzfrequenz auszugeben, wobei das Steuersignal dazu neigt, die Phasenverschiebung zu annullieren.

6. Sende-/Empfangsvorrichtung eines Nahfeld-Übertragungssystems nach Anspruch 4 oder 5, bei welcher das Phasenverschiebungsmessungsmittel (33; 43) eingerichtet ist zum:

- Erzeugen eines Messsignals mit einer Frequenz, die der Nennfrequenz des Übertragungssystems oder einer der Nennfrequenz benachbarten Frequenz gleich ist,
- Eingeben des Messsignals an den Eingang des Schwingkreises,
- Erfassen des Messsignals am Ausgang des Schwingkreises,
- Messen der Phasenverschiebung zwischen dem erfassten Signal und dem Messsignal, und
- Steuern der Mittel, die der Schwingkreis zum Modifizieren seiner Resonanzfrequenz umfasst, damit die so gemessene Phasenverschiebung annulliert wird.

7. Sende-/Empfangsvorrichtung eines Nahfeld-Übertragungssystems nach Anspruch 6, bei welcher das Phasenverschiebungsmessungsmittel (33; 43) zum Erzeugen des Messsignals Folgendes umfasst:

- einen ersten Erzeuger (431), dessen Sendefrequenz der Nennfrequenz des Übertragungssystems oder einer der Nennfrequenz benachbarten Frequenz gleich ist,
- einen zweiten Erzeuger (432), dessen Sendefrequenz im Wesentlichen niedriger als diejenige des ersten Erzeugers (431) ist,
- einen Modulator (433), der an seinen Eingängen die durch die ersten und zweiten Erzeuger (431 und 432) erzeugten Signale empfängt und als Messsignal ein Signal ausgibt, dessen Sendefrequenz die Summe oder die Differenz der Sendefrequenzen der Erzeuger (431 und 432) ist.

8. Sende-/Empfangsvorrichtung eines Nahfeld-Übertragungssystems nach Anspruch 7, bei welcher der Modulator (433) aus einem Multiplizierer (50), der an seinen Eingängen die durch die ersten und zweiten Erzeuger (431 und 432) erzeugten Signale empfängt, einem Filter (51), dessen Eingang mit dem Ausgang des Multiplizierers (50) verbunden ist, besteht, wobei der Filter (51) zum Filtern eines der Seitenbänder des Signals am Ausgang des Multiplizierers (50) und zum Passieren des anderen Seitenbands eingerichtet ist, wobei das Messsignal das Ausgangssignal des Filters (51) ist.

9. Sende-/Empfangsvorrichtung eines Nahfeld-Übertragungssystems nach Anspruch 7, bei welcher der Modulator (433) aus einem ersten und zweiten Multiplizierer (60a und 60b), sowie einem ersten und zweiten Phasenverschieber (61a und 61b) um $\pi/2$ besteht, wobei der erste Multiplizierer (60a) an einem Eingang das durch den ersten Erzeuger (431) erzeugte Signal und an dem anderen Eingang das durch den zweiten Erzeuger (432) nach einer Phasenverschiebung in dem zweiten Phasenverschieber (61b) erzeugte Signal empfängt, und der zweite Multiplizierer (60b) an einem Eingang das durch den zweiten Erzeuger (432) erzeugte Signal und an dem anderen Eingang das durch den ersten Erzeuger (431) nach einer Phasenverschiebung im ersten Phasenverschieber (61a) erzeugte Signal empfängt, wobei der Ausgang jedes Multiplizierers (60a, 60b) mit dem Eingang eines Summierers (62) oder demjenigen einer Einheit verbunden ist, die die Differenz ausführt, deren Ausgang das Messsignal ausgibt.

10. Sende-/Empfangsvorrichtung eines Nahfeld-Übertragungssystems nach einem der Ansprüche 7 bis 9, bei welcher das Phasenverschiebungsmessungsmittel, zum Messen der Phasenverschiebung zwischen dem Messsignal und dem Messsignal nach dem Passieren des Schwingkreises, Folgendes umfasst:

    - Erfassungseinheit (434), die an einem Eingang das Messsignal nach dem Passieren des Schwingkreises (12; 22; 32) und an dem anderen Eingang das durch den zweiten Erzeuger (431) erzeugte Signal empfängt, und an ihrem Ausgang ein Signal ausgibt, das an der Sendefrequenz des zweiten Erzeugers (432) und dessen Phase eine lineare Funktion der Phasenverschiebung ist, der das Messsignal im Schwingkreis ausgesetzt war, und
    - einen Phasenkomparator (435), der an einem Eingang das durch die Erfassungseinheit (434) ausgegebene Signal und an dem anderen Eingang das durch den ersten Erzeuger (432) erzeugte Signal empfängt und an seinem Ausgang das Steuersignal ausgibt, das von der Phasenverschiebung abhängt.

11. Sende-/Empfangsvorrichtung eines Nahfeld-Übertragungssystems nach Anspruch 10, bei welcher die Erfassungseinheit (434) aus einem Multiplizierer (70), der an seinen Eingängen das Messsignal nach Passieren des Schwingkreises (12; 22; 32) und das durch den zweiten Erzeuger (431) erzeugte Signal empfängt, und einem Filter (71) besteht, dessen Eingang mit dem Ausgang des Multiplizierers (70) verbunden ist, wobei der Filter (71) zum Filtern eines der Seitenbänder des Signals am Ausgang des Multiplizierers (70) und zum Passieren des anderen Seitenbands eingerichtet ist.

12. Sende-/Empfangsvorrichtung eines Nahfeld-Übertragungssystems nach Anspruch 10, bei welcher die Erfassungseinheit (434) aus einem ersten und zweiten Multiplizierer (80a und 80b), sowie einem ersten und zweiten Phasenverschieber (91a und 91b) um $\pi/2$ besteht, wobei der erste Multiplizierer (80a) an einem Eingang das Messsignal nach dem Passieren des Schwingkreises (12; 22; 32) und an dem anderen Eingang das durch den zweiten Erzeuger (431) nach einer Phasenverschiebung im zweiten Phasenverschieber (81b) erzeugte Signal empfängt, und der zweite Multiplizierer (80b) an einem Eingang das durch den zweiten Erzeuger (431) erzeugte Signal und am anderen Eingang das nach dem Passieren des Schwingkreises (12; 22; 32) nach einer Phasenverschiebung im ersten Phasenverschieber (81a) gemessene Signal empfängt, wobei der Ausgang jedes Multiplizierers (80a; 80b) mit dem Eingang eines Summierers (82) oder demjenigen einer Einheit verbunden ist, die die Differenz ausführt.

13. Sende-/Empfangsvorrichtung eines Nahfeld-Übertragungssystems nach einem der Ansprüche 6 bis 12, bei welcher das Phasenverschiebungsmessungsmittel (43) zum Steuern der Mittel, die der Schwingkreis (12; 22; 32) zum Modifizieren seiner Resonanzfrequenz umfasst, eine Steuereinheit (436) umfasst, die an ihrem Eingang das Phasenverschiebungssignal empfängt und ein Polarisierungssignal der Steuermittel des Schwingkreises (12; 22; 32) ausgibt, dessen Amplitude eine solche ist, dass die gemessene Phasenverschiebung Null ist.

14. Sende-/Empfangsvorrichtung eines Nahfeld-Übertragungssystems nach einem der Ansprüche 4 bis 13, bei welcher der Schwingkreis (12; 22; 32) eine Induktivität umfasst, die mit einer Kapazität parallel gekoppelt ist, wobei die Induktivität als Antenne der Sende-/Empfangsvorrichtung dient.

15. Sende-/Empfangsvorrichtung eines Nahfeld-Übertragungssystems nach einem der Ansprüche 4 bis 13, bei welcher der Schwingkreis einen Transformator mit symmetrischen Wicklungen (324) umfasst, wobei die Wicklungen parallel mit diesen gleichwertigen Kapazitäten gekoppelt sind, wobei der Transformator als Antenne der Sende-/Empfangsvorrichtung dient.

16. Sende-/Empfangsvorrichtung eines Nahfeld-Übertragungssystems nach Anspruch 14 oder 15, bei welcher die Kapazität oder jede Kapazität eine variable gesteuerte Kapazität ist.

17. Sende-/Empfangsvorrichtung eines Nahfeld-Übertragungssystems nach Anspruch 16, bei welcher die Kapazität oder jede Kapazität aus mehreren Kapazitäten (C1 bis Cn) besteht, die mittels Schaltelementen ($200_1$ bis $200_n$) auf schaltbare Weise je mit mindestens einer anderen parallel geschaltet werden können.

18. Sende-/Empfangsvorrichtung eines Nahfeld-Übertragungssystems nach Anspruch 17, bei welcher jedes Schaltelement durch eines der Ausgangsbits eines Analog/Digital Umwandlers (200) gesteuert wird, der das Phasenverschiebungssignal empfängt, das durch das Phasenverschiebungsmessungsmittel (43) ausgegeben wird.

19. Sende-/Empfangsvorrichtung eines Nahfeld-Übertragungssystems nach einem der Ansprüche 7 bis 18, bei welcher der erste Erzeuger (431) ein Erzeuger von sinusförmigen Signalen ist.

20. Sende-/Empfangsvorrichtung eines Nahfeld-Übertragungssystems nach einem der Ansprüche 7 bis 19, bei welcher der zweite Erzeuger (432) ein Erzeuger von sinusförmigen Signalen ist.

21. Sende-/Empfangsvorrichtung eines Nahfeld-Übertragungssystems nach einem der Ansprüche 7 bis 19, bei welcher der zweite Erzeuger ein Erzeuger von pseudo-zufälligen Sequenzen ist.

22. Sende-/Empfangsvorrichtung eines Nahfeld-Übertragungssystems nach Anspruch 21, bei welcher der Erzeuger von pseudo-zufälligen Sequenzen zum Senden derjenigen Frequenzen ein primitives Erzeugungspolynom Modulo 2 verwendet.

Fig. 1

Fig. 2a

Fig. 2b

Déphasage entre Vs et Ve

f0

Fig. 2c

Fig. 3

Fig. 4

Fig. 5

Fig. 6

EP 2 009 790 B1

Fig. 7a

Fig. 7b

Fig. 8a

Fig. 8b

91a 90a 435

91b 90b

92

Fig. 9a

435

100a

100b

XOR

101

102

Fig. 9b

Fig. 10

Fig. 11a

EP 2 009 790 B1

Fig. 11b

Fig. 12

**EP 2 009 790 B1**

**Documents brevets cités dans la description**

- EP 0663724 A